# EUROPÄISCHE PATENTSCHRIFT

(11) **EP 4 223 189 B1**
(45) Veröffentlichungstag und Bekanntmachung des Hinweises auf die Patenterteilung: **05.03.2025**
(21) Anmeldenummer: 23153602.0
(22) Anmeldetag: 27.01.2023
(51) Int. Cl.: A47C 29/00, A47C 31/00

(54) **SCHLAFZELLE MIT EINEM SCHLAFBEREICH UND EINEM ELEKTRISCH LEITENDEN VORHANG**
SLEEPING CELL WITH A SLEEPING ZONE AND AN ELECTRICALLY CONDUCTIVE CURTAIN
CELLULE DE COUCHAGE COMPRENANT UNE ZONE DE COUCHAGE ET UN RIDEAU ÉLECTROCONDUCTEUR

(30) Priorität: 08.02.2022 AT 372022
(43) Veröffentlichungstag der Anmeldung: 09.08.2023
(73) Patentinhaber: SH Immobilien GmbH, 6700 Bludenz (AT)
(72) Erfinder: SCHWARZHANS, Ernst, 6700 Bludenz (AT)
(74) Vertreter: Torggler & Hofmann Patentanwälte - Rankweil

(56) Entgegenhaltungen:
- DE-U1- 202020 101 200
- KR-B1- 100 415 946

## Beschreibung

Die vorliegende Erfindung betrifft eine Schlafzelle mit einem Schlafbereich und einem elektrisch leitenden Vorhang, der um den Schlafbereich herum anordenbar ist, gemäß den Merkmalen des Oberbegriffs des Anspruchs 1.

### HINTERGRUND UND STAND DER TECHNIK

Es gibt eine Vielzahl unterschiedlichster Schlafzellen, die sich auf ebenso unterschiedlichste Art und Weise das Prinzip eines faradayschen Käfigs zunutze machen.

Eine mobile Abschirmhülle gegen Elektrosmog für ein Bett wird in der Schrift DE 202020101200 offenbart. Hier kann mittels eines Abschirmstoffes auf einer Matratze und einem Traggestell als Support für einen zweiten Abschirmstoff eine Schlafstelle als Faraday'scher Käfig aufgebaut werden.

Eine andere Schrift ist US 2021038458 (Sleep Enclosure Systems). Hierbei handelt es sich um eine Schlafzelle, die ebenfalls als Faraday'scher Käfig ausgebildet ist. Diese Zelle weist eine bewegliche Tür auf, die durch einen Mechanismus aufgeklappt werden kann, sodass die Schlafzelle geöffnet ist und eine Person den Schlafraum betreten kann.

Eine weitere Schrift ist CN 211459557 U (Radiation-proof mosquito net). Bei diesem Gebrauchsmuster handelt es sich um ein geerdetes Netz, welches sowohl als Moskitoschutz als auch als Schutz vor diverser Strahlung diverser elektronischer Geräte dient.

Eine weitere Schrift ist AT 508627 A1 (Wellnesseinrichtung). Bei dieser Einrichtung handelt es sich um eine bettähnliche Konstruktion mit verschiedenen Features, um den Wohlfühleffekt eines Benutzers oder einer Benutzerin zu steigern. Neben einer Beleuchtung, einer Beduftungseinrichtung oder auch einer Akustikeinrichtung ist eine Beheizungseinrichtung vorgesehen. Das Prinzip eines faradayschen Käfigs beschränkt sich bei dieser Erfindung ausschließlich auf die Beheizungseinrichtung. KR 100 415 946 B1 offenbart eine Schlafzelle gemäß dem Stand der Technik.

Abschließend soll noch zum Stand der Technik folgendes Gebrauchsmuster hinzugezählt werden. Es handelt sich um die Schrift DE 202004007037 U1 (System zur Dämpfung oder Abschirmung einer auf eine Schlafstelle einwirkenden äußeren elektromagnetischen Strahlung oder eines darauf einwirkenden äußeren elektrischen Feldes). Hierbei handelt es sich um eine Schlafstelle, die mit zwei Geweben ausgeführt ist. Diese beiden Gewebe bestehen aus einem elektrisch leitenden Material und sind lösbar miteinander verbunden. Indem die beiden elektrisch leitfähigen Gewebeteile zumindest bereichsweise eine Schlafstelle umgeben, kommt es ebenfalls zu einem Effekt eines faradayschen Käfigs.

Allen bisher genannten Schriften sind folgende Vorteile gemein. Alle Erfindungen nützen den Effekt eines faradayschen Käfigs, um innerhalb der Schlafzelle vor dem Einwirken außerhalb befindlicher elektrischer oder elektromagnetischer Felder zu schützen. Dies soll insbesondere einen positiven Effekt auf das Schlafverhalten der BenutzerIn haben.

Nachteilig bei vorliegenden Schriften und dem derzeitigen Stand der Technik ist, dass die Begrenzung des Schlafbereichs durch elektrisch leitende Materialien nicht komfortabel geöffnet oder geschlossen werden kann. In den meisten Fällen ist ein Stoff, der bis auf den Boden reicht, von unten heraufzuheben, bis über den Kopf, um den Schlafbereich zu betreten. In anderen Fällen ist der Schlafbereich durch feststehendes Material wie beispielsweise Wände nur über eine Seite, die eine Tür aufweist, betretbar.

### BESCHREIBUNG DER ERFINDUNG

Die Aufgabe der vorliegenden Erfindung ist eine Schlafzelle mit einem Schlafbereich und einem elektrisch leitenden Vorhang bereitzustellen, wobei der elektrisch leitende Vorhang auf einfache Weise verschoben werden kann, um damit den Schlafbereich komfortabel zu öffnen oder zu verschließen.

Hinsichtlich der vorliegenden Erfindung wird dies durch die Merkmale des Anspruchs 1 gelöst, nämlich indem ein Schienensystem vorgesehen ist, mittels welchem der leitende Vorhang verschiebbar gelagert ist, wobei das Schienensystem zumindest eine Schiene beinhaltet, das Schienensystem eine Vielzahl von Verbindungselementen beinhaltet, die Verbindungselemente mit dem leitenden Vorhang verbunden sind und in der zumindest einen Schiene verschiebbar gelagert sind sowie das Schienensystem so ausgebildet ist, dass der leitende Vorhang mit der zumindest einen Schiene elektrisch leitend verbunden ist, vorzugsweise dass der leitende Vorhang über die Schiene geerdet ist.

Um den Effekt eines Faraday'schen Käfigs voll auszuschöpfen, kann die Schlafzelle nach allen Seiten vollständig mit elektrisch leitenden Materialien umhüllt sein. Die Mantelfläche der Schlafzelle kann mit dem verschiebbaren Vorhang, die Unterseite mit einem Teppich und die Oberseite mit einem Baldachin umschlossen werden. Dabei sollten alle Begrenzungen entweder vollständig oder zumindest teilweise aus elektrisch leitenden Materialien gefertigt sein, beispielsweise elektrisch leitende Folien oder elektrisch leitender Farbanstrich für Teppich sowie Baldachin und Stoffgewebe mit elektrisch leitenden Fäden für den Vorhang. Damit es sich um einen vollständig geschlossenen Faraday'schen Käfig handelt, sollte der Vorhang auf dem Teppich aufliegen oder diesen zumindest teilweise berühren. Die Verbindungselemente stellen ebenfalls eine elektrisch leitende Verbindung zwischen Baldachin und Vorhang dar, wodurch ein geschlossener Faraday'scher Käfig entsteht.

Die Schlafzelle kann geerdet sein, wobei die erdende Leitung vom Schienensystem ausgehend in eine Haushaltsteckdose münden kann. Die Erdung der Schlafzelle kann auch auf jede andere Art erfolgen. Neben dem Schienensystem kann auch jeder andere Teil der Schlafzelle zusätzlich und/oder stattdessen geerdet sein. Außerdem kann ein eigener Erdungsstecker vorgesehen sein, der kompatibel mit handelsüblichen Steckdosen ist. Zusätzlich kann zwischen diesem Stecker und dem Schienensystem auch ein Überspannungsschutz vorgesehen sein, der einen Schutz bei gefährlichen Überspannungen durch beispielsweise Blitzeinschläge darstellt.

Durch den Einsatz von Verbindungselementen zwischen zumindest einer Schiene und zumindest einem Vorhang lässt sich der zumindest eine Vorhang entlang der Schiene beliebig verschieben. Auf diese Weise kann der Vorhang den gesamten Schlafbereich freilegen, indem dieser so weit wie möglich zusammen geschoben ist, oder den gesamten Schlafbereich umhüllen, indem dieser auf die maximale Länge entlang der Schiene auseinander geschoben ist. Jede Stellung zwischen einer völlig freigelegten und einer maximal geschlossenen Stellung ist durch die frei verschiebbaren Verbindungsstücke und die vorhandenen Vorhänge möglich.

Verschiedene Teppiche zum Abschluss der Unterseite der Schlafzelle sind möglich. Dabei kann der Teppich einerseits aus einer isolierenden Schicht, die direkt am Fußboden aufliegt, bestehen und andererseits eine elektrisch leitende Folie oder einen elektrisch leitenden Farbanstrich auf der Isolationsschicht aufweisen, um den Faraday'schen Käfig nach unten hin abzuschließen. Verschiedene Größen, Designs, Formen und Farben sind sowohl für den isolierenden Teil als auch den elektrisch leitenden Teil möglich. Einsetzbare Materialien werden lediglich durch ihre Funktion als Isolationsschicht oder elektrisch leitende Schicht begrenzt.

Verschiedene Designs können sowohl die Funktionalität als auch die Ästhetik bedienen. So kann die Schlafzelle beispielsweise auf beiden Seiten des Schlafbereiches je einen Vorhang bereitstellen. Die Anzahl der Vorhangteile bzw. - abschnitte ist nicht begrenzt, wobei mindestens ein Vorhang vorgesehen ist, der im Wesentlichen den Schlafbereich abschirmt. Es kann aber natürlich auch eine Wand vorgesehen sein, die zum Beispiel das Kopfende begrenzt. Diese Wand kann wie der Baldachin aus Vollmaterial, als Textil oder auch als Folie gefertigt sein. Um den Effekt des Faraday'schen Käfigs voll auszunützen, sollte eine solche Wand jedenfalls, wenn der Vorhang nicht die Abschirmung um den ganzen Umfang des Schlafbereiches übernimmt, ebenfalls elektrisch leitend sein.

Eine weitere Variante betrifft den Baldachin, der in verschiedensten Ausführungsformen gefertigt werden kann. Nicht darauf beschränkt, kann dieser zum Beispiel als plattenartiges Gebilde über dem Schlafbereich ausgeführt sein, an dessen Rändern das Schienensystem entlangläuft. Dabei folgt sowohl der Baldachin als auch das Schienensystem einer rechteckigen oder quadratischen Form. Im Gegensatz dazu kann das Schienensystem aber auch jedwede andere Form aufweisen, wie beispielsweise eine Kreis- oder Kreisabschnittsform. Wie bei Betthimmeln üblich kann der Baldachin mit einer Vielzahl von Zierapplikationen und/oder Zierstoffen geschmückt werden.

Infolge der variantenreichen Ausführungsformen der Schlafzelle ist diese für alle üblichen Betten geeignet. So kann eine erfindungsgemäße Schlafzelle für ein Doppelbett, Einzelbett, Stockbett oder auch für Kinderbetten verwendet werden, wobei die genannten Bettvarianten nicht als beschränkend verstanden werden sollen. Bei letztgenanntem Beispiel kann der Vorhang mit einem kreisförmigen Schienensystem um den gesamten Umfang eines Kinder- oder Gitterbettes herum angeordnet werden. Dadurch ist durch den verschiebbaren Vorhang ein sehr komfortables und bequemes Abschirmen des Schlafbereiches bei gleichzeitig leichtem Zugang zum Schlafbereich möglich. Damit kann jede Seite des Bettes leicht geöffnet und geschlossen werden, wo ansonsten der Stoff vom Boden aufgehoben, bis auf Kopfhöhe hochgehoben und mit einer Hand festgehalten werden muss. Wenn beide Hände gebraucht werden, wie beim Niederlegen von Kleinkindern üblich, bleibt nur die Möglichkeit den Stoff über den eigenen Kopf nach hinten zu werfen, womit man sich selbst im Schlafbereich befindet. Bei Verlassen des Schlafbereiches kann es dann leicht zu Stolpergefahr kommen. Infolgedessen kann das einfache Öffnen und Schließen einer Schlafzelle mit einem verschiebbaren sowie elektrisch leitenden Vorhang sowohl eine Verbesserung hinsichtlich des Benutzungskomforts als auch einen Beitrag zur Unfallprävention sowie -vermeidung darstellen.

In einer weiteren komfortablen Ausführungsform kann das Schienensystem auch zwei parallellaufende Schienen aufweisen, wodurch zwei Vorhänge unabhängig voneinander verschoben werden können. Dies erlaubt eine noch einfachere lückenlose Abschirmung durch sich überlappende Vorhänge. Mit anderen Worten kann dann der Schlafbereich abgetrennt werden, ohne dass es zu einem lästigen Spalt zwischen zwei Vorhängen auf derselben Schiene kommt. Ein solches Doppel-Schienensystem kann auch als Fenstervorhänge verwendet werden.

Zusätzlich können auch Beleuchtungsmittel in der Schlafzelle vorgesehen sein. Um beispielsweise die Nachtlektüre zu lesen, könnten LED-Leuchten im Baldachin oder andernorts im Schlafbereich installiert werden. Entsprechende Bedienungselemente können überall im Schlafbereich installiert sein, wobei sich hier eine das Kopfende abschließende Wand sehr anbietet. In einer solchen Seitenwand können Lichtschalter, die Batterie- oder Akkugehäuse und Leitungen zu den Leuchtmitteln im Baldachin vorgesehen sein. Die Stromzufuhr kann in diesem Fall durch einen Haushaltsstromanschluss erfolgen. Damit die Abschirmung der Schlafzelle voll funktionstüchtig ist, kann natürlich ein Akku- oder Batteriebetrieb die Beleuchtungsmittel versorgen. Damit herrscht im Inneren der Schlafzelle zwar ein gewisses elektrisches Feld, aber dennoch bleibt die Abschirmung vor äußeren elektrischen oder elektromagnetischen Feldern intakt.

Unter elektrisch leitenden Materialien können hier alle allgemein bekannten Stoffe verstanden werden, die aufgrund ihres spezifischen Widerstands oder ihrer elektrischen Leitfähigkeit in der Lage sind, als Leiter Strom zu übertragen. Diese Materialien sind vor allem Metalle und metallische Verbindungen, Halbleitermaterialien, leitfähige Polymere, Ionenleiter oder dotierte Materialien. Wie allgemein bekannt, zählen Isolatoren (Nichtleiter) nicht zu den elektrischen Leitern. Eine Auswahl an üblichen Leitermaterialien umfasst Silber, Kupfer oder auch Stahl. Vertreter an Halbleitermaterialien sind beispielsweise Silizium oder Galliumarsenid. Typische Isolatoren sind beispielsweise Bernstein oder auch Kunststoffe wie Silikone. Jedes für die erfindungsgemäße Anwendung ausreichend elektrisch leitende Material kann verwendet werden und beschränkt sich nicht auf die genannten Beispiele. Als Orientierungshilfe kann jedoch 10¹² Ω·mm²/m als überschlagsmäßige Obergrenze des spezifischen Widerstands herangezogen werden. Die meisten elektrisch leitenden Materialien weisen eher einen spezifischen Widerstand bis zu 10⁸ Ω·mm²/m auf.

Unter Batterien werden hier alle elektrischen Energiespeicher und vor allem Primärbatterien verstanden. Unter Akkus werden hier Akkumulatoren verstanden, konkret mehrfach aufladbare Batterien bzw. Sekundärbatterien. Daraus folgt, dass die Aufzählung von "Batterien und Akkus" in diesem Dokument redundant ist, da Batterien im weitesten Sinne auch Sekundärbatterien miteinschließen. Zum klareren Verständnis, besonders in Hinblick auf Laien, wird aber die hier genützte und redundante Formulierung beibehalten.

Weitere vorteilhafte Ausführungsformen der Erfindung werden in den abhängigen Ansprüchen definiert.

Damit die Verbindungselemente verschiebbar gelagert sind, kann in einer bevorzugten Ausführungsform die Schiene des Schienensystems einen Vorsprung entlang ihrer Längsachse bzw. entlang der Schienenachse aufweisen.

Wie erwähnt, kann der Vorsprung sich über die gesamte Länge der Schiene oder nur über Teilbereiche der Schiene erstrecken.

In einer weiteren Ausführungsform können die Verbindungselemente Gleit- und/oder Rollenelemente aufweisen, die für die verschiebbare Lagerung auf dem zumindest einen vorher genannten Vorsprung aufliegen. Damit kann eine leicht herzustellende verschiebbare Lagerung erreicht werden und damit die Verbindungselemente entlang der Schienenachse bewegt werden.

In einer weiteren Ausführungsform kann der Schlafbereich nach unten mit einem elektrisch leitenden Teppich begrenzt werden, um den Effekt des faradayschen Käfigs zu unterstützen.

In einer weiteren Ausführungsform kann zusätzlich ein elektrisch leitender Baldachin oberhalb der Schlafzelle eingesetzt werden, um eine Begrenzung einzuführen und den faradayschen Käfig nach oben hin abzuschließen. Als Baldachin soll in diesem Zusammenhang eine obere Abgrenzung der Schlafzelle im weitesten Sinne gemeint sein. Es handelt sich also um einen sogenannten Himmel (Traghimmel) eines Bettes im weitesten Sinne.

In einer besonders bevorzugten Ausführung kann dieser Baldachin entweder aus Vollmaterial, als Folie und/oder als Textil ausgeführt sein. Die verwendbaren Materialien und Konstruktionen sind dabei nicht durch hier genannte Ausführungsformen - oder varianten begrenzt. Alle Materialien und Konstruktionslösungen, die den Effekt des Faraday'schen Käfigs zumindest teilweise ausnützen, können hier zur Anwendung kommen. Es bietet sich allerdings an, wie bei Baldachinen üblich, ein leichtes Material bzw. eine leichte Konstruktion zu verwenden.

In einer besonders bevorzugten Ausführung kann der Baldachin frei von der Decke herunterhängen oder auf Stehelementen aufliegen oder von einer Wand vorstehend oder durch eine Kombination der vorher genannten Optionen angeordnet sein.

In einer bevorzugten Ausführungsform kann die Mantelfläche des Schlafbereichs zusätzlich zum elektrischen leitenden Vorhang auf zumindest einer Seite mit zumindest einer Wand begrenzt werden. Dies hat besonders dann einen Vorteil, wenn der Baldachin aus einem Vollmaterial gefertigt sein sollte und somit eine abschließende Wand größere Unterstützung bilden kann. Abgesehen davon kann diese Ausführungsform, besonders wenn der Schlafbereich an einer Wand oder in einer Ecke eines Raumes positioniert ist, einen ästhetischen Mehrwert bieten. Zusätzlich kann eine Wand den Vorteil bieten, Platz für Bedienelemente, Batterien und/oder Akkus sowie Leitungen zu den Beleuchtungsmitteln bereitzustellen.

In einer bevorzugten Ausführungsform können die elektrisch leitenden Verbindungselemente als Gleit- und/oder als Rolllager ausgeführt sein. Damit soll besonders der Komfort beim Verschieben des Vorhanges erhöht werden. Eine Kombination von verschiedenen Lagern ist ebenso möglich, wie auch die Möglichkeit, dass die Schiene und/oder der Vorsprung der Schiene nicht kontinuierlich über die gesamte Umfangslänge des Systems durchgängig sein müssen. Beispielsweise könnte eine Unterbrechung des Vorsprunges der Schiene das schnellere und einfachere (De)Montieren von Vorhängen ermöglichen.

In einer weiteren bevorzugten Ausführungsform können diese elektrisch leitenden Verbindungselemente einen elektrisch leitenden Vorhang tragen. Dies funktioniert entweder über eine form-, kraft- und/oder eine stoffschlüssige Verbindung zwischen den Verbindungselementen und dem Vorhang. Bevorzugt kann ein Verbindungselement über eine Klemmfläche den elektrisch leitenden Vorhang tragen oder auch durch Stifte, die durch Ösen des Vorhanges und der Verbindungselemente durchgesteckt und damit miteinander verbunden sein können. Die Verbindung zwischen den Verbindungselementen und dem elektrisch leitenden Vorhang ist ebenfalls elektrisch leitend.

In einer bevorzugten Ausführungsform kann innerhalb der Schlafzelle ein Beleuchtungsmittel vorgesehen sein. Dies hat besonders dann einen Vorteil, wenn beispielsweise ein Buch in der Schlafzelle gelesen werden soll. Die Stromversorgung hierfür kann durch externe Stromquellen erfolgen. In einer besonders bevorzugten Ausführungsvariante kann innerhalb der Schlafzelle eine Stromquelle durch Batterien oder Akkus angedacht sein. Auf diese Weise herrscht zwar im Inneren der Schlafzelle ein elektrisches Feld, dennoch bleibt die Funktion des Faraday'schen Käfigs bestehen, indem äußere elektrische oder elektromagnetische Felder abgeschirmt werden können.

In einer bevorzugten Ausführungsform kann entweder der elektrisch leitende Vorhang, der elektrisch leitende Teppich, die elektrisch leitende Wand, der elektrisch leitende Baldachin und/oder das elektrisch leitende Schienensystem über eine elektrische Leitung geerdet sein. Diese Erdung kann mit einem eigenen Kabel von der Schlafzelle ausgehen und zu einer handelsüblichen Steckdose geführt werden. Es ist auch möglich zwischen dem Bett und der handelsüblichen Steckdose einen Überspannungsschutz vorzusehen, der einen zusätzlichen Sicherheitseffekt darstellen kann. Auf diese Weise kann ein zusätzlicher Schutz vor Strom oder Brandunfällen gegeben sein.

In einer besonders bevorzugten Ausführungsform ist die Schlafzelle als Faraday'scher Käfig ausgebildet. Dies kann heißen, dass die Schlafzelle als komplett in sich geschlossener elektrisch leitender Hohlkörper verstanden werden kann. Damit kann dieser Hohlkörper als nahezu in sich geschlossene Hülle, ohne etwaige Durchlässe, gesehen werden. Es ist, wie bei Faraday'schen Käfigen üblich, auch möglich, dass es sich um einen lückenhaft geschlossenen Käfig handeln kann. Es kann vorgesehen sein, dass elektrisch leitende Lücken baulicher sowie konstruktiver Natur oder aufgrund der verwendeten Materialien zustande kommen können. Im Speziellen ist es möglich, dass das verwendete Stoffgewebe für den Vorhang nicht ausschließlich aus elektrisch leitendem Material gefertigt ist. Dadurch entstehen Lücken im Faraday'schen Käfig. In bevorzugten Ausführungen können solche Lücken in Kauf genommen oder sogar geplant sein und gleichzeitig der Effekt eines Faraday'schen Käfigs genützt werden.

Weitere Vorteile und Einzelheiten der Erfindung ergeben sich aus den Figuren sowie der dazugehörigen Figurenbeschreibung. Dabei zeigen:
- Fig. 1: Perspektivische Ansicht einer Ausführungsvariante einer Schlafzelle mit Schienendetails
- Fig. 2: Vorderansicht einer Schlafzelle inklusive Draufsicht und Ausführungsbeispielen für Schienen und Verbindungselemente
- Fig. 3: Vorderansicht einer Schlafzelle mit einem kreisförmigen Schienensystem und einem kuppelartigen Baldachin
- Fig. 4: Seitenansicht einer Ausführungsvariante mit einem Gitterbett für Kinder
- Fig. 5: Perspektivische Ansicht einer Ausführungsvariante mit Gitterbett für Kinder inklusive Detailansicht vom kreisförmigen Schienensystem sowie Erdungssystem mit Leitung, Stecker und Überspannungsschutz
- Fig. 6: Perspektivische Ansicht eines Doppel-Schienensystems und einer Stoppvorrichtung für ein Verbindungselement
- Fig. 7: Verschiedene Ausführungsvarianten eines Teppichs

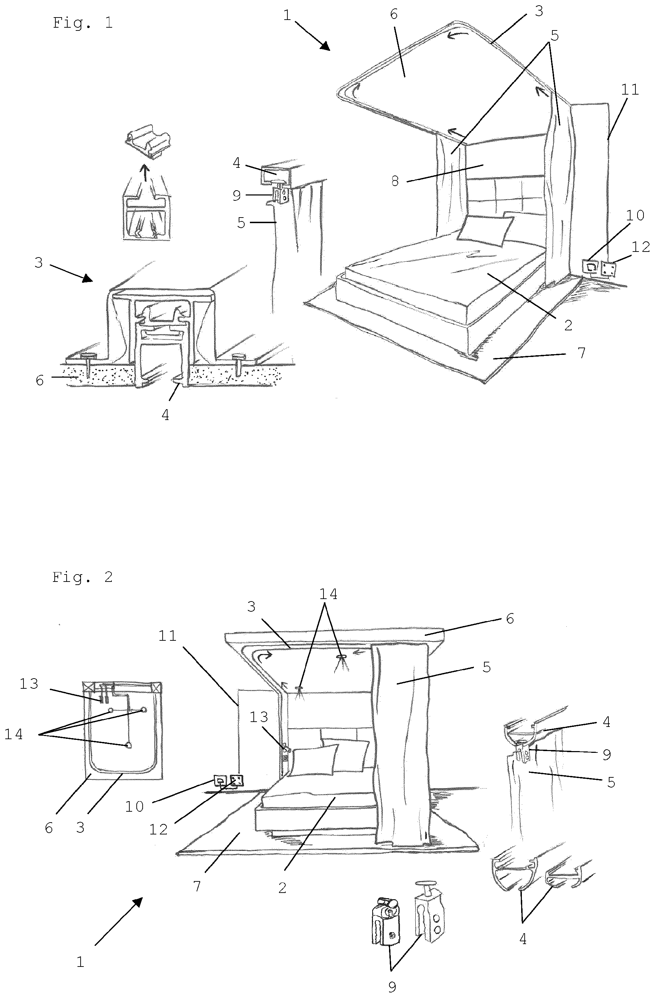

Fig. 1 zeigt ein Ausführungsbeispiel einer erfindungsgemäßen Schlafzelle 1 mit einem Schlafbereich. In diesem Beispiel steht ein großes Bett 2 im Schlafbereich. Darüber ist der rechteckige Baldachin 6 mit einem am äußeren Rand befestigten Schienensystem 3, welches unter anderem eine Schiene 4 beinhaltet. Am Kopfende des Bettes 2 ist eine Wand 8. Es befinden sich an den Seiten zwei separate Vorhänge 5. Das Bett 2 steht auf einem Teppich 7. Neben dem Bett ist eine Erdungsleitung 11 abgebildet, die vom Schienensystem 3 ausgehend über einen Überspannungsschutz 12 durch den Erdungsstecker 10 in einer Haushaltssteckdose mündet.

In der Detailansicht ist gezeigt, dass das Schienensystem 3 von oben auf dem Baldachin 6 befestigt werden kann und mehrere miteinander formschlüssig verbundene Teile unter anderem die Schiene 4 umfassen können. In einer weiteren Detailansicht ist ein Verbindungselement 9 gezeigt, welches gleitend in der Schiene 4 verschoben werden kann und den Vorhang 5 trägt.

Fig. 2 zeigt eine ähnliche Ausführungsvariante einer Schlafzelle 1 wie Figur 1 in der Vorderansicht. Zusätzlich sind hier im Baldachin 6 drei Beleuchtungsmittel 14 vorgesehen, die mit Bedienelementen 13 gesteuert werden können. In einer Detailansicht können die Beleuchtungsmittel 14 und deren Leitungen zu den Bedienelementen 13 aus Draufsicht erkannt werden. In weiteren Detailansichten sind jeweils zwei verschiedene Ausführungsvarianten der Verbindungselemente 9 und der Schiene 4 zu sehen. Die Verbindungselemente 9 weisen T-förmige Lagerelemente auf, um in das Profil der Schiene 4 eingefädelt und darin verschiebbar gelagert zu werden Mit einer vertikalen Klemmspalte in den Verbindungselementen 9 kann der Vorhang 5 eingeklemmt und/oder mit Stiften durch die Ösen der Verbindungselemente 9 befestigt werden. Außerdem zeigt eine weitere Detailansicht eine Schiene 4 in Wirkverbindung mit einem Verbindungselement 9, welches den Vorhang 5 trägt und als Gleitlager entlang der Schienenachse verschoben werden kann.

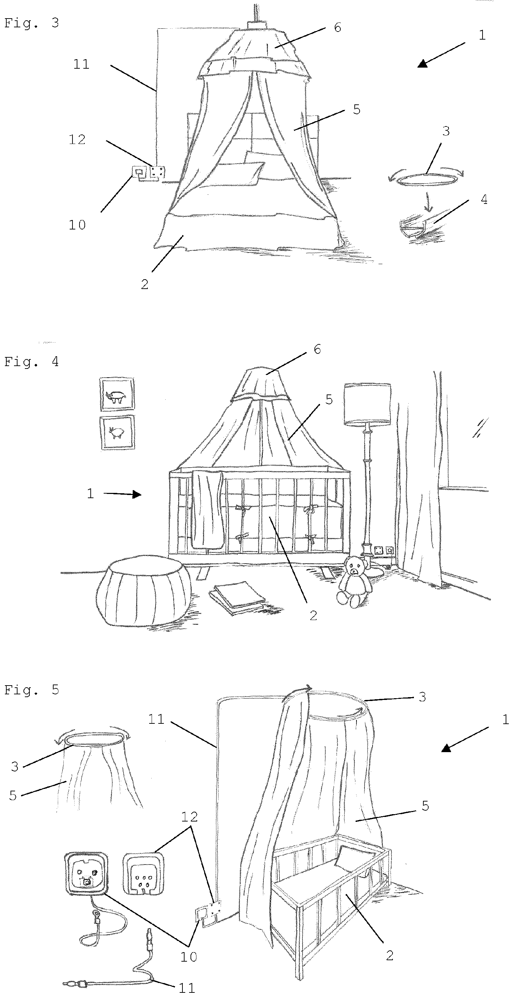

Fig. 3 zeigt eine weitere Ausführungsvariante einer Schlafzelle 1, wobei in diesem Fall der Baldachin 6 kuppelartig ausgeprägt ist. Infolgedessen beschreibt das Schienensystem 3 eine runde Form. Die kreisförmige Schiene 4 ist in einer Detailansicht dargestellt. Diese besteht vergleichbar mit Ausführungen in Fig. 2 aus einer Profilstange mit einem entsprechenden Querschnitt, geeignet zum Halten der Verbindungselemente 9 als Gleitlager. Eine Erdung des Baldachins 6 ist hier wie bisher mit einem Erdungsstecker 10, einer Erdungsleitung 11 und einem Überspannungsschutz 12 ebenfalls vorgesehen.

Fig. 4 zeigt eine weitere Ausführungsvariante einer Schlafzelle 1 mit einem Gitterbett 2 für Kinder. Wie bei Fig. 3 ist hier ein kreisrundes Schienensystem 3 vorhanden, wodurch das gesamte Bett 2 mit einem Vorhang 5 umhüllt werden kann. Wegen einer Zierdecke ist das Schienensystem 3 in dieser Figur nicht erkennbar.

Fig. 5 zeigt die Ausführungsvariante einer Schlafzelle 1 von Fig. 4 aus einer anderen Perspektive und ohne Zierdecke des Baldachins 6, wodurch das kreisrunde Schienensystem 3 erkennbar ist. Entlang der gebogenen Schiene 4 kann der Vorhang 5 verschoben werden. Wie bei allen anderen Ausführungsformen kann auch hier eine Erdung erfolgen, indem das Schienensystem 3 mit einer Erdungsleitung 11 über einen Überspannungsschutz 12 mit Hilfe eines Erdungssteckers 10 in einer Haushaltssteckdose mündet. In einer Detailansicht sind diese Vorrichtungen separat als Einzelteile gezeigt.

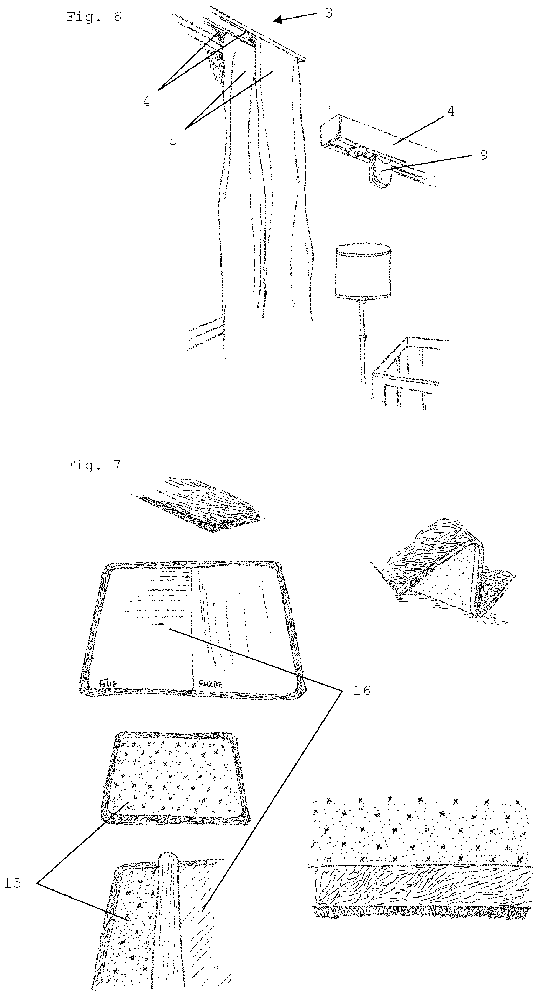

Fig. 6 zeigt eine weitere Ausführungsvariante eines Schienensystems 3 mit zwei parallellaufenden Schienen 4.Es können somit zwei voneinander unabhängige Vorhänge 5 verschoben werden und sich gegenseitig überlappen, um eine lückenlose Abschirmung herzustellen. Ein solches Doppel-Schienensystem kann wie in der Figur 6 angedeutet auch für einen Fenstervorhang verwendet werden. Eine weitere Detailansicht zeigt eine Schiene 4 mit einem Stopper, der die Verschiebestrecke des Verbindungselements 9 begrenzt. Das Verbindungselement 9 nützt in dieser Variante einen Klemmkopf zum Tragen des Vorhanges 5.

Fig. 7 zeigt verschiedene Ansichten des Teppichs 7. Dieser kann aus einer am Boden aufliegenden Isolierschicht 15 und einer elektrisch leitenden Folie 16 bestehen. Die Folie 16 kann, wie in einer Detailansicht dargestellt, einfach über den Teppich ausgerollt werden. Alternativ oder zusätzlich kann auch statt einer elektrisch leitenden Folie auch ein elektrisch leitender Farbanstrich verwendet werden.

### L e g e n d e zu den Hinweisziffern:

- 1: Schlafzelle
- 2: Bett
- 3: Schienensystem
- 4: Schiene
- 5: Vorhang
- 6: Baldachin
- 7: Teppich
- 8: Wand
- 9: Verbindungselement
- 10: Erdungsstecker
- 11: Erdungsleitung
- 12: Überspannungsschutz
- 13: Bedienungselement (evtl. inklusive Akku- und Batterie)
- 14: Beleuchtungselement
- 15: Isolierschicht
- 16: Folie oder Anstrich

## Patentansprüche

1. Schlafzelle (1) mit einem Schlafbereich und einem elektrisch leitenden Vorhang (5), der um den Schlafbereich herum anordenbar ist, **dadurch gekennzeichnet, dass** ein Schienensystem (3) vorgesehen ist, mittels welchem der leitende Vorhang (5) verschiebbar gelagert ist, wobei
- das Schienensystem (3) zumindest eine Schiene (4) beinhaltet,
- das Schienensystem (3) eine Vielzahl von Verbindungselementen (9) beinhaltet,
- die Verbindungselemente (9) mit dem leitenden Vorhang (5) verbunden sind und in der zumindest einen Schiene (4) verschiebbar gelagert sind sowie
das Schienensystem (3) so ausgebildet ist, dass der leitende Vorhang (5) mit der zumindest einen Schiene (4) elektrisch leitend verbunden ist, vorzugsweise dass der leitende Vorhang über die Schiene (4) geerdet ist.

2. Schlafzelle (1) nach Anspruch 1, **dadurch gekennzeichnet, dass** die zumindest eine Schiene (4) des Schienensystems (3) mit zumindest einem Vorsprung zum Lagern der Verbindungselemente (9) ausgeführt ist, wobei sich der Vorsprung entlang einer Schienenachse der Schiene (4) erstreckt.

3. Schlafzelle (1) nach Anspruch 2, **dadurch gekennzeichnet, dass** die Verbindungselemente (9) jeweils Gleit- und/oder Rollelemente aufweisen, die für die verschiebbare Lagerung auf dem zumindest einen Vorsprung aufliegen.

4. Schlafzelle (1) nach wenigsten einem der vorangegangenen Ansprüche, **dadurch gekennzeichnet, dass** der Schlafbereich nach unten hin mit einem elektrisch leitenden Teppich (7) begrenzt ist.

5. Schlafzelle (1) nach wenigsten einem der vorangegangenen Ansprüche, **dadurch gekennzeichnet, dass** der Schlafbereich nach oben hin mit einem elektrisch leitenden Baldachin (6) begrenzt ist.

6. Schlafzelle (1) nach Anspruch 5, **dadurch gekennzeichnet, dass** der Baldachin (6) frei hängend von der Decke, auf Stehelementen aufliegend und/oder vorstehend von einer Wand (8) angeordnet ist.

7. Schlafzelle (1) nach wenigsten einem der vorangegangenen Ansprüche, **dadurch gekennzeichnet, dass** die Mantelfläche des Schlafbereiches durch mindestens eine elektrisch leitende Wand (8) begrenzt ist.

8. Schlafzelle (1) nach wenigsten einem der vorangegangenen Ansprüche, **dadurch gekennzeichnet, dass** der Baldachin (6), Wände (8), Vorhänge (5) und/oder der Teppich (7) zumindest teilweise aus elektrisch leitendem Vollmaterial, als elektrisch leitende Folie (16), als elektrisch leitendes Textil und/oder mit elektrisch leitendem Farbanstrich (16) ausgeführt ist.

9. Schlafzelle (1) nach wenigsten einem der vorangegangenen Ansprüche, **dadurch gekennzeichnet, dass** die elektrisch leitenden Verbindungselemente (9) über eine form-, kraft- und/oder stoffschlüssige Verbindung den elektrisch leitenden Vorhang (5) tragen, wobei diese Verbindung eine elektrische Leitung zwischen dem Verbindungselement (9) und dem Vorhang (5) gewährleistet.

10. Schlafzelle (1) nach wenigsten einem der vorangegangenen Ansprüche, **dadurch gekennzeichnet, dass** innerhalb der Schlafzelle (1) mindestens ein Beleuchtungsmittel (14) vorgesehen ist.

11. Schlafzelle (1) nach wenigsten einem der vorangegangenen Ansprüche, **dadurch gekennzeichnet, dass** der elektrisch leitende Vorhang (5), der elektrisch leitende Teppich (7), die elektrisch leitende Wand (8), der elektrisch leitende Baldachin (6) und/oder das elektrisch leitende Schienensystem (3) über eine elektrische Leitung geerdet ist.

12. Schlafzelle (1) nach Anspruch 11, **dadurch gekennzeichnet, dass** die Erdung einen Überspannungsschutz (12) miteinschließt.

13. Schlafzelle (1) nach wenigsten einem der vorangegangenen Ansprüche, **dadurch gekennzeichnet, dass** die Schlafzelle (1) als Faraday'scher Käfig ausgebildet ist

## Claims

1. Sleeping compartment (1) with a sleeping region and an electrically conductive curtain (5) which can be arranged around the sleeping region, **characterised in that** a rail system (3) is provided by means of which the conductive curtain (5) is mounted in a displaceable manner, wherein
- the rail system (3) has at least one rail (4),
- the rail system (3) has a multiplicity of connecting elements (9),
- the connecting elements (9) being connected to the conductive curtain (5) and being mounted in the at least one rail (4) in a displaceable manner and
the rail system (3) is configured such that the conductive curtain (5) is connected to the at least one rail (4) in an electrically conducting manner, preferably that the conductive curtain is earthed via the rail (4).

2. Sleeping compartment (1) according to claim 1, **characterised in that** the at least one rail (4) of the rail system (3) is equipped with at least one protrusion for mounting the connecting elements (9), wherein the protrusion extends along a rail axis of the rail (4).

3. Sleeping compartment (1) according to claim 2, **characterised in that** the connecting elements (9) each have sliding and/or rolling elements which rest on the at least one protrusion for the displaceable mounting.

4. Sleeping compartment (1) according to at least one of the preceding claims, **characterised in that** the sleeping region is delimited towards a bottom by an electrically conductive rug (7).

5. Sleeping compartment (1) according to at least one of the preceding claims, **characterised in that** the sleeping region is delimited towards to a top by an electrically conductive canopy (6).

6. Sleeping compartment (1) according to claim 5, **characterised in that** the canopy (6) is arranged to hang freely from the ceiling, to rest on upright elements and/or to protrude from a wall (8).

7. Sleeping compartment (1) according to at least one of the preceding claims, **characterised in that** the lateral surface of the sleeping region is delimited by at least one electrically conductive wall (8).

8. Sleeping compartment (1) according to at least one of the preceding claims, **characterised in that** the canopy (6), walls (8), curtains (5) and/or the rug (7) are at least partially embodied from at least one of an electrically conductive solid material, an electrically conductive film (16), an electrically conductive textile or an electrically conductive coat of paint (16).

9. Sleeping compartment (1) according to at least one of the preceding claims, **characterised in that** the electrically conductive connecting elements (9) bear the electrically conductive curtain (5) by at least one of a form-fitting, force-fitting or materially bonded connection, wherein this connection ensuring electrical conduction between the connecting element (9) and the curtain (5).

10. Sleeping compartment (1) according to at least one of the preceding claims, **characterised in that** at least one light (14) is provided within the sleeping compartment (1).

11. Sleeping compartment (1) according to at least one of the preceding claims, **characterised in that** the electrically conductive curtain (5), the electrically conductive rug (7), the electrically conductive wall (8), the electrically conductive canopy (6) and/or the electrically conductive rail system (3) is earthed via an electrical line.

12. Sleeping compartment (1) according to claim 11, **characterised in that** the earthing includes an overvoltage protection device(12).

13. Sleeping compartment (1) according to at least one of the preceding claims, **characterised in that** the sleeping compartment (1) is configured as a Faraday cage

## Revendications

1. Cellule de couchage (1) avec une zone de couchage et un rideau (5) conducteur d'électricité qui peut être disposé autour de la zone de couchage, **caractérisée en ce qu'**il est prévu un système de rails (3) au moyen duquel le rideau (5) conducteur est logé de manière déplaçable,
- le système de rails (3) comprenant au moins un rail (4),
- le système de rails (3) comprenant une pluralité d'éléments de liaison (9),
- les éléments de liaison (9) étant reliés au rideau (5) conducteur et étant montés de manière à pouvoir coulisser dans ledit au moins un rail (4), et
le système de rails (3) est conçu de telle sorte que le rideau (5) conducteur est relié de manière électriquement conductrice audit au moins un rail (4), de préférence de telle sorte que le rideau conducteur est mis à la terre par le biais du rail (4).

2. Cellule de couchage (1) selon la revendication 1, **caractérisée en ce que** ledit au moins un rail (4) du système de rails (3) est réalisé avec au moins une saillie pour loger les éléments de connexion (9), la saillie s'étendant le long d'un axe de rail du rail (4).

3. Cellule de couchage (1) selon la revendication 2, **caractérisée en ce que** les éléments de liaison (9) sont munis chacun d'éléments de glissement et/ou de roulement qui reposent sur ladite moins une saillie pour le logement coulissant.

4. Cellule de couchage (1) selon au moins l'une des revendications précédentes, **caractérisée en ce que** la zone de couchage est délimitée vers le bas par un tapis (7) conducteur d'électricité.

5. Cellule de couchage (1) selon au moins l'une des revendications précédentes, **caractérisée en ce que** la zone de couchage est délimitée vers le haut par un baldaquin (6) conducteur d'électricité.

6. Cellule de couchage (1) selon la revendication 5, **caractérisée en ce que** le baldaquin (6) est suspendu librement au plafond, repose sur des éléments verticaux et/ou est disposé en dépassant d'un mur (8).

7. Cellule de couchage (1) selon au moins l'une des revendications précédentes, **caractérisée en ce que** la surface d'enveloppe de la zone de couchage est délimitée par au moins une paroi (8) conductrice d'électricité.

8. Cellule de couchage (1) selon au moins l'une des revendications précédentes, **caractérisée en ce que** le baldaquin (6), les parois (8), les rideaux (5) et/ou le tapis (7) sont réalisés au moins en partie en un matériau plein conducteur d'électricité, sous forme d'une feuille (16) conductrice d'électricité, d'un textile conducteur d'électricité et/ou avec une couche de peinture (16) conductrice d'électricité.

9. - Cellule de couchage (1) selon au moins l'une des revendications précédentes, **caractérisée en ce que** les éléments de liaison (9) conducteurs d'électricité portent le rideau (5) conducteur d'électricité par une liaison par complémentarité de forme, une liaison de force et/ou une liaison de matière, cette liaison assurant une conduction électrique entre l'élément de liaison (9) et le rideau (5).

10. Cellule de couchage (1) selon au moins l'une des revendications précédentes, **caractérisée en ce qu'**au moins un moyen d'éclairage (14) est prévu à l'intérieur de la cellule de couchage (1).

11. Cellule de couchage (1) selon au moins l'une des revendications précédentes, **caractérisée en ce que** le rideau (5) conducteur d'électricité, le tapis (7) conducteur d'électricité, la paroi (8) conductrice d'électricité, le baldaquin (6) conducteur d'électricité et/ou le système de rails (3) conducteur d'électricité sont mis à la terre par un câble électrique.

12. Cellule de couchage (1) selon la revendication 11, **caractérisée en ce que** la mise à la terre comprend une protection contre les surtensions (12).

13. Cellule de couchage (1) selon au moins l'une des revendications précédentes, **caractérisée en ce que** la cellule de couchage (1) est conçue comme une cage de Faraday.
